Europäisches Patentamt

European Patent Office

Office européen des brevets

(11) Veröffentlichungsnummer: **0 304 510**
**A1**

(12) **EUROPÄISCHE PATENTANMELDUNG**

(21) Anmeldenummer: 87112522.5

(51) Int. Cl.⁴: **G01D 11/12**

(22) Anmeldetag: **28.08.87**

(43) Veröffentlichungstag der Anmeldung:
**01.03.89 Patentblatt 89/09**

(84) Benannte Vertragsstaaten:
**FR GB IT**

(71) Anmelder: **VDO Adolf Schindling AG**
**Gräfstrasse 103**
**D-6000 Frankfurt/Main(DE)**

(72) Erfinder: **Lindig, Christian**
**Rossertstrasse 5a**
**D-6233 Kelkheim(DE)**
Erfinder: **Heinisch, Peter**
**Rheinlandstrasse 21**
**D-6231 Schwalbach(DE)**
Erfinder: **Duffait, Roland**
**Bremer Strasse 2-6**
**D-6236 Eschborn(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Messeinrichtung.**

(57) Eine Dämpfungseinrichtung für eine drehbare Welle (1) eines Meßwerkes hat auf der Welle (1) eine Verdickung (2) in Form einer Kugel oder eines Rhomboids. Diese Verdickung (2) bildet mit der Innenmantelfläche eines koaxial zur Welle (1) angeordneten Rohres (3) einen Kapillarspalt (4), in dem eine Dämpfungsflüssigkeit (5) durch Kapillarkräfte gehalten ist.

FIG.1

EP 0 304 510 A1

## Meßeinrichtung

Die Erfindung bezieht sich auf eine eine Dämpfungsflüssigkeit aufweisende Dämpfungseinrichtung für eine drehbare Welle eines Meßwerkes. Solche Dämpfungseinrichtungen sind zum Beispiel in Drehmagnet-Quotientenmeßwerken vorgesehen und allgemein bekannt.

Bei einem bekannten Meßwerk ist die Dämpfungseinrichtung durch eine flüssigkeitsgefüllte Kammer gebildet, in die eine Zeigerwelle mit einem freien Ende hineinragt. Um eine möglichst genau festgelegte Dämpfung zu erzielen, ist es erforderlich, daß die Zeigerwelle stets gleich weit in die Dämpfungskammer ragt. Auch muß sichergestellt sein, daß die Dämpfungskammer entspechend der geforderten Menge mit Dämpfungsflüssigkeit gefüllt ist und an der Durchführung der Zeigerwelle in die Dämpfungskammer hinein keine Undichtigkeiten auftreten. Diese Erfordernisse werden in der Praxis mit vertretbarem Aufwand nur unvollkommen erfüllt, so daß die Dämpfungswirkung von Meßwerk zu Meßwerk verschieden ist und gelegentlich auch im Laufe der Zeit geringer wird.

Der Erfindung liegt die Aufgabe zugrunde, eine Dämpfungseinrichtung der eingangs genannten Art derart zu gestalten, daß mit möglichst geringem Aufwand eine bei verschiedenen Meßwerken möglichst einheitliche, genau festlegbare und im Laufe der Zeit sich nicht verändernde Dämpfung erzielbar ist.

Diese Aufgabe wird erfindungsgemäß dadurch gelöst, daß die Welle in einem Teilbereich von einem Kapillarspalt umgeben und die Dämpfungsflüssigkeit in dem Kapillarspalt vorgesehen ist.

Eine solche Dämpfungseinrichtung arbeitet nach einem neuen Dämfpungsprinzip. Bei ihr werden zur Erzielung der Dämpfung Kapillarkräfte benutzt. Durch eine entsprechende Bemessung des Kapillarspaltes läßt sich die Dämpfungswirkung sehr exakt einstellen. Da die Welle nach beiden Seiten hin aus dem Kapillarspalt ragen kann, spielt ihre genaue Position in axialer Richtung keine Rolle. Da infolge der Kapillarwirkung die Dämpfungsflüssigkeit von selbst im Kapillarspalt verbleibt, erfordert die Dämpfungseinrichtung keine Dichtungen zur Abdichtung der Dämpfungskammer. Auch die Menge der Dämpfungsflüssigkeit im Kapillarspalt ist zwangsläufig konstant, da sich die Dämpfungsflüssigkeitsmenge infolge der Kapillarkräfte zwangsläufig einstellt und überschüssige Dämpfungsflüssigkeit von selbst abläuft. Die erfindungsgemäße Dämpfungseinrichtung eignet sich ganz besonders für in Kraftfahrzeuge eingebaute Meßwerke, da sie sehr schwingungsunempfindlich ist.

Eine konstruktiv besonders e nfache Ausführungsform der Erfindung besteht darin, daß der Kapillarspalt durch ein die Welle umgebendes Rohr und einer bis nahe zur Innenmantelfläche des Rohres reichenden Verdickung der Welle gebildet ist. Es kann sich bei der Verdickung meist um ein separates Bauteil handeln, welches auf der Welle aufgeschoben ist. Denkbar ist auch eine Kombination derart, daß ein Teil des Dämpfungskörpers von einem auf der Welle sitzenden Teil (oder der Welle selbst) und der andere Teil von einem die Welle umgebenden Teil gebildet wird. Dies ist die fertigungstechnisch einfachste Lösung.

Ein optimales Dämpfungsverhalten erzielt man, wenn die Verdickung eine Kugel ist.

Fertigungstechnisch günstiger und hinsichtlich des Dämpfungsverhaltens immer noch ausreichend ist es jedoch, wenn die Verdickung ein Rhomboid ist. Eine solche Ausführungsform bietet auch die Möglichkeit, die Dämpfungswirkung durch unterschiedliche Längen des Rhomboids zu beeinflussen.

Statt auf der Welle eine Verdickung vorzusehen, kann man in kinematischer Umkehrung des Dämpfungsprinzips auch den Kapillarspalt durch ein eine Verengung aufweisendes, die Welle umgebendes Außenteil bilden.

Denkbar ist es auch, das Rohr nach unten hin abzuschließen und bis über den Kapillarspalt mit Dämpfungsflüssigkeit zu füllen. Da sich die Dämpfungsflüssigkeit jedoch im Kapillarspalt von selbst hält, ist ein solcher Aufwand unnötig. Deshalb ist es vorteilhafter, wenn der Kapillarspalt nach beiden Enden hin offen ist und gleichem Luftdruck unterliegt.

Eine weitere, vorteilhafte Ausgestaltung der Erfindung besteht darin, daß die Welle durch eine zylindrische Ausnehmung des Außenteils geführt ist und mit einem Zylinderstück unter Bildung des Kapillarspaltes in diese Ausnehmung ragt. Eine solche Ausführungsform stellt die fertigungstechnisch einfachste Lösung der gestellten Aufgabe dar.

Ist am freien Ende des in die zylindrische Ausnehmung ragenden Zylinderstücks der Übergang von der zylindrischen Mantelfläche in die Stirnfläche durch eine radial umlaufende Fase gebildet oder ist die Mündung der zylindrischen Ausnehmung, durch die das Zylinderstück in die Ausnehmung ragt, mit einer radial umlaufenden Fase ausgebildet, so werden in den Bereichen der Fasen Reservemengen an Dämpfungsflüssigkeit gespeichert, die sich bei Bedarf in den Spalt 4 hineinziehen. Vorzugsweise weist die Fase einen Neigungswinkel von etwa 45° zur Drehachse der Welle auf.

Die Erfindung läßt zahlreiche Ausführungsformen zu. Zu ihrer weiteren Verdeutlichung sind vier davon in der Zeichnung dargestellt und werden nachfolgend beschrieben. In ihr zeigen die

Fig. 1 einen Längsschnitt durch eine erste Ausführungsform einer erfindungsgemäßen Dämpfungseinrichtung,

Fig. 2 einen Längsschnitt durch eine zweite Ausführungsform einer erfindungsgemäßen Dämpfungseinrichtung,

Fig. 3 einen Längsschnitt durch eine dritte Ausführungsform einer erfindungsgemäßen Dämpfungseinrichtung,

Fig. 4 einen Längsschnitt durch eine vierte Ausführungsform einer erfindungsgemäßen Dämpfungseinrichtung.

Fig. 5 einen Querschnitt durch ein Drehmagnet-Quotienten-Meßwerk mit einer Dämpfungseinrichtung nach Fig. 4.

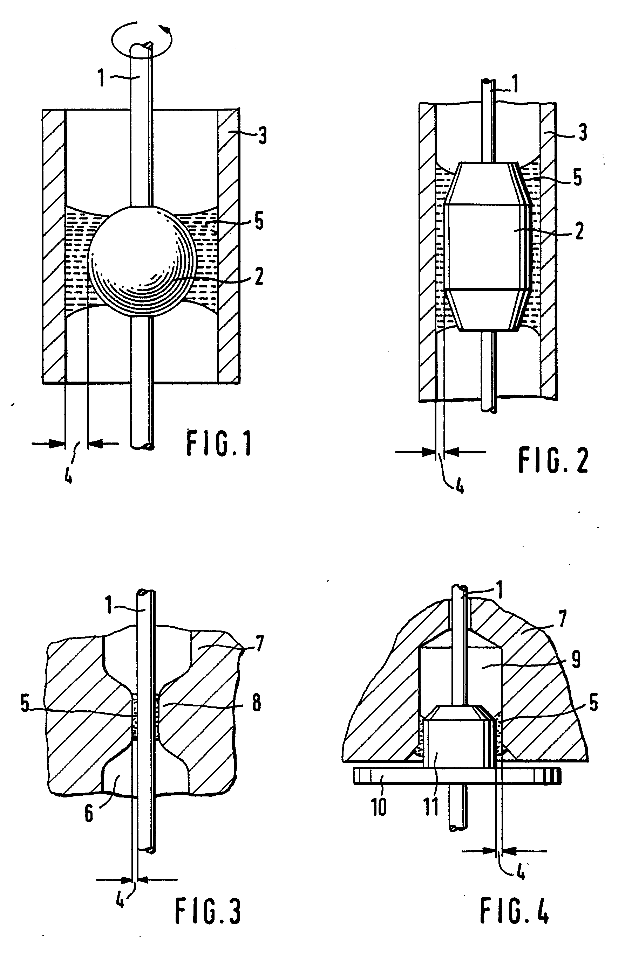

Die Figur 1 zeigt eine Welle 1 eines Meßwerkes. Bei dieser Welle 1 kann es sich beispielsweise um die Zeigerwelle des Meßwerkes handeln. Auf der Welle 1 ist eine Verdickung 2 in Form einer Kugel angeordnet. Koaxial zur Welle 1 befindet sich ein Rohr 3, das einen solchen Durchmesser hat, daß zwischen ihm und der Verdickung 3 ein Kapillarspalt 4 entsteht, in dem sich eine Dämpfungsflüssigkeit 5 befindet. Das Rohr 3 ist nach oben und unten hin offen, so daß die Dämpfungsflüssigkeit 5 ausschließlich durch Kapillarkräfte in dem

Die Ausführungsform nach der Figur 2 unterscheidet sich von der zuvor beschriebenen ausschließlich dadurch, daß die Verdickung 2 aus Fertigungsgründen statt von einer Kugel durch einen Rhomboid gebildet ist. Die Dämpfungsflüssigkeit befindet sich wiederum in dem Kapillarspalt 4 zwischen der Außenmantelfläche der durch den Rhomboid gebildeten Verdickung 3 und der Innenmantelfläche des Rohres 3. Zusätzlich befindet sich Dämpfungsflüssigkeit 5 in den beiden durch die Kegelstumpfmantelflächen des Rhomboids begrenzten Räumen oberhalb und unterhalb des Kapillarspaltes 4. Diese Flüssigkeitsmengen stellen ein Reservoir für die Dämpfungsflüssigkeit dar. Diese wird dort durch Oberflächenspannungen gehalten. Der Winkel der Kegelstumpfflächen, welcher in der Größenordnung von 20° sein kann, bestimmt unter anderem die dort gespeicherte Ölmenge.

Die in Figur 3 gezeigte Dämpfungseinrichtung stellt eine kinematische Umkehr des Dämpfungsprinzips nach den beiden vorherigen Ausführungsformen dar. Die Welle 1 ist hier durch eine Öffnung 6 eines Außenteils 7 geführt. Diese Öffnung 6 weist eine Verengung 8 auf, so daß der die Dämpfungsflüssigkeit 5 aufweisende Kapillarspalt 4 zwischen der Welle 1 und der Innnmantelfläche dieser Verengung 8 gebildet wird.

Bei der Ausführungsform gemäß der Figur 4 weist das Außenteil 7 eine von der Welle 1 durchdrungene zylinderische Ausnehmung 9 auf, in welche ein auf der Welle 1 angeordnetes, hutförmiges Bauteil 10 mit einem Zylinderstück 11 mit Spiel hineingreift, so daß wiederum der Kapillarspalt 4 entsteht, in dem sich die Dämpfungsflüssigkeit 5 befindet.

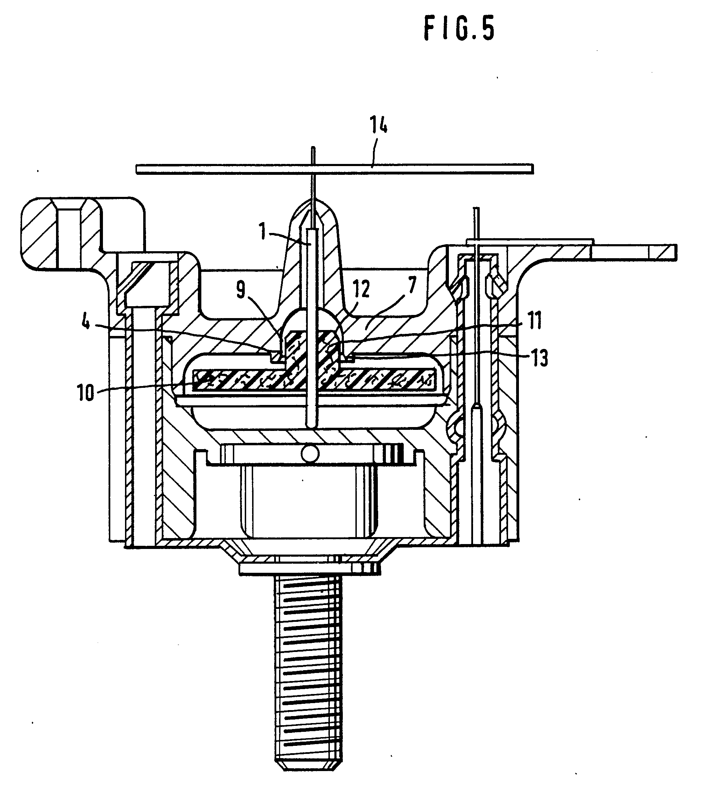

Figur 5 zeigt die Dämpfungseinrichtung nach Figur 4 in einem Drehmagnet-Quotienten-Meßwerk. Das hutförmige Bauteil 10 mit dem Zylinderstück 11 ist dabei ein radial magnetisierter Dauermagnet-Rotor, der vorzugsweise einteilig aus kunststoffgebundenem Magnetmaterial besteht. Das Außenteil 7, in dem die Ausnehmung 9 ausgebildet ist, ist der Wickelkörper des Meßwerks, auf den die nicht dargestellten Spulen aufgewickelt werden.

Das freie Ende der Welle 1 trägt einen Zeiger 14, durch den die vom Meßwerk erfaßten Meßwerte anzeigbar sind.

Wie auch in Figur 4 zu sehen ist, ist das freie Ende des Zylinderstücks 11 mit einer Fase 12 und die Mündung der Ausnehmung 9 mit einer Fase 13 versehen. Durch Oberflächenspannung hält sich eine bestimmte Menge Dämpfungsflüssigkeit 5 auch in den Bereichen der Fasen 12 und 13. Diese Dämpfungsflüssigkeit im Bereich der Fasen 12 und 13 dient als Reserve-Dämpfungsflüssigkeit, die sich bei Verlust von Dämpfungsflüssigkeit selbsttätig in den Spalt 4 hineinzieht.

## Ansprüche

1. Eine Dämpfungsflüssigkeit aufweisende Dämpfungseinrichtung für eine drehbare Welle eines Meßwerkes, dadurch gekennzeichnet, daß die Welle (1) in einem Teilbereich von einem Kapillarspalt (4) umgeben und die Dämpungsflüssigkeit (5) in dem Kapillarspalt (4) vorgesehen ist.

2. Dämpfungseinrichtung nach Anspruch 1, dadurch gekennzeichnet, daß der Kapillarspalt (4) durch ein die Welle (1) umgebendes Rohr (3) und einer bis nahe zur Innenmantelfläche des Rohres (3) reichenden Verdickung (2) der Welle (1) gebildet ist.

3. Dämpfungseinrichtung nach Anspruch 2, dadurch gekennzeichnet, daß die Verdickung (2) eine Kugel ist.

4. Dämpfungseinrichtung nach Anspruch 2, dadurch gekennzeichnet, daß die Verdickung (2) Rhomboid ist.

5. Dämpfungseinrichtung nach Anspruch 1, dadurch gekennzichnt, daß der Kapillarspalt (4) durch ein eine Verengung (8) aufweisendes, die Welle (1) umgebendes Außenteil (7) gebildet ist.

6. Dämpfungseinrichtung nach einem oder mehreren der vorangehenden Ansprüche, dadurch gekennzeichnet, daß der Kapillarspalt (4) nach beiden Enden hin offen ist und gleichem Luftdruck unterliegt.

7. Dämpfungseinrichtung nach einem oder mehreren der vorangehenden Ansprüche, dadurch gekennzeichnet, daß die Welle (1) durch eine zylindrische Ausnehmung (9) des Außenteils (7) geführt ist und mit einem Zylinderstück (11) unter Bildung des Kapillarspaltes (4) in diese Ausnehmung (9) ragt.

8. Dämpfungseinrichtung nach Anspruch 7, dadurch gekennzeichnet, daß am freien Ende des in die zylindrische Ausnehmung (9) ragenden Zylinderstücks (11) der Übergang von der zylindrischen Mantelfläche in die Stirnfläche durch eine radial umlaufende Fase (12) gebildet ist.

9. Dämpfungseinrichtung nach Anspruch 7, dadurch gekennzeichnet, daß die Mündung der zylinderischen Ausnehmung (9), durch die das Zylinderstück (11) in die Ausnehmung (9) ragt, mit einer radial umlaufenden Fase (13) ausgebildet ist.

10. Dämpfungseinrichtung nach einem der Ansprüche 8 und 9, dadurch gekennzeichnet, daß die Fase (12 und/oder 13) einen Neigungswinkel von etwa 45° zur Drehachse der Welle (1) aufweist.

FIG.1

FIG.2

FIG.3

FIG.4

FIG.5

Europäisches
Patentamt

# EUROPÄISCHER RECHERCHENBERICHT

Nummer der Anmeldung

EP 87 11 2522

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-2 569 311 (S.C. HOARE et al.) <br> * Figur 4; Spalte 4, Zeile 72 - Spalte 5, Zeile 15 * <br> --- | 1,2,4,6 | G 01 D 11/12 |
| X | US-A-3 111 623 (V.S. THOMANDER) <br> * Figur 14; Spalte 16, Zeilen 18-29 * <br> --- | 1 | |
| X | CH-A- 346 611 (T. STAUB) <br> * Seite 1, Zeilen 28-50 * <br> --- | 1,6-8 | |
| X | DE-A-1 673 974 (METRAWATT) <br> * Seite 3, Absatz 3 * <br> --- | 1 | |
| X | US-A-3 439 273 (F.A. SILLS) <br> * Spalte 3, Zeilen 3-15 * <br> ----- | 1,2 | |

RECHERCHIERTE
SACHGEBIETE (Int. Cl.4)

G 12 B
G 01 D

Der vorliegende Recherchenbericht wurde für alle Patentansprüche erstellt

| Recherchenort | Abschlußdatum der Recherche | Prüfer |
|---|---|---|
| DEN HAAG | 14-04-1988 | TOUSSAINT F.M.A. |